# EUROPEAN PATENT APPLICATION

(11) **EP 4 790 519 A1**
(43) Date of publication of application: **12.08.2026**
(21) Application number: 25225184.8
(22) Date of filing: 18.12.2025
(51) Int. Cl.: G06F 1/20, H05K 7/20

(54) **CONTINUOUS REFRIGERANT MONITORING FOR PUMPED TWO-PHASE COOLING SYSTEM**

(30) Priority: 26.12.2024 US 202463738998 P
(71) Applicant: Vertiv Corporation, Westerville, OH 43082 (US)
(72) Inventor: Wise, Ashley Elizabeth, Westerville 43082 (US); Kindig, Caryl Elise, Westerville 43082 (US); Tipton, Russell Charles, Westerville 43082 (US)
(74) Representative: Cousens, Nico

(57) **Abstract**

A system and method for continuous real-time monitoring of charge levels, e.g., fluid refrigerant available within a refrigerant reservoir of a pumping apparatus for a two-phase cooling system, receives power data corresponding to a current load drawn by each server or information technology (IT) device served by the pumping apparatus. Based on the received power data, the controller infers the expected charge level, e.g., the proportion of fluid refrigerant that should be remaining within the refrigerant reservoir as opposed to circulating in the secondary fluid network of the cooling system, and compares the expected charge level to an actual current charge level sensed within the refrigerant reservoir, initiating a gentle system shutdown and/or generating an alert if the actual charge level sufficiently deviates from the expected charge level based on the received power data.

## Description

The present application claims the benefit under 35 U.S.C. § 119(e) of U.S. Provisional Patent Application Serial Number 63/738,998 filed December 26, 2024.

### TECHNICAL FIELD

The present disclosure is directed generally to the field of cooling systems for data centers and similar controlled-temperature environments, and more particularly, to monitoring of two-phase pumping systems within a cooling system.

### BACKGROUND

As data center environments trend toward increasing densification of servers, switches, and other information technology (IT) devices (due to, e.g., artificial intelligence (AI), machine learning (ML), large language models (LLM), and other high performance computing (HPC) applications), demand will likewise increase for pumped two-phase cooling systems. For example, pumped two-phase systems may provide lower secondary flow rates and warmer chilled-water temperatures. Further, pumped two-phase systems are unique in requiring a single charge (e.g., a single fluid refrigerant circulated through the secondary loop) for either zero-load or maximum-load operations, but present a similarly unique challenge in monitoring the charge in the cooling system. As pumped two-phase servers continue to be installed or removed from a system, the overall charge may incrementally decrease over time.

The pumped two-phase system must guard against low charge at maximum load, which may result in a failure condition, e.g., a dry-out where insufficient heat transfer to the fluid refrigerant leads to overheating and/or throttling of server processing units (e.g., central processing units (CPU), graphics processing units (GPU)). At any point during normal operations, however, customers have no efficient way of knowing whether sufficient charge remains as fluid levels fluctuate according to the current load or, e.g., if a leak in the secondary loop occurs and is repaired.

### BRIEF DESCRIPTION OF THE FIGURES

The detailed description is described with reference to the accompanying figures. The use of the same reference numbers in different instances in the description and the figures may indicate similar or identical items. Various embodiments or examples ("examples") of the present disclosure are disclosed in the following detailed description and the accompanying drawings. The drawings are not necessarily to scale. In general, operations of disclosed processes may be performed in an arbitrary order, unless otherwise provided in the claims. In the drawings:
FIG. 1 is a block diagram of a pumped two-phase cooling system serving one or more IT devices according to example embodiments of the inventive concepts disclosed herein;
FIG. 2 is a diagrammatic illustration of load conditions of the pumped two-phase cooling system of FIG. 1 and corresponding charge levels; and
and FIGS. 3A through 3C are process flow diagrams illustrating a method for continuous charge level monitoring of a pumped two-phase cooling system according to example embodiments of the inventive concepts disclosed herein.

### DETAILED DESCRIPTION

Before explaining one or more embodiments of the disclosure in detail, it is to be understood that the embodiments are not limited in their application to the details of construction and the arrangement of the components or steps or methodologies set forth in the following description or illustrated in the drawings. In the following detailed description of embodiments, numerous specific details may be set forth in order to provide a more thorough understanding of the disclosure. However, it will be apparent to one of ordinary skill in the art having the benefit of the instant disclosure that the embodiments disclosed herein may be practiced without some of these specific details. In other instances, well-known features may not be described in detail to avoid unnecessarily complicating the instant disclosure.

As used herein a letter following a reference numeral is intended to reference an embodiment of the feature or element that may be similar, but not necessarily identical, to a previously described element or feature bearing the same reference numeral (e.g., 1, 1a, 1b). Such shorthand notations are used for purposes of convenience only and should not be construed to limit the disclosure in any way unless expressly stated to the contrary.

Further, unless expressly stated to the contrary, "or" refers to an inclusive or and not to an exclusive or. For example, a condition A or B is satisfied by any one of the following: A is true (or present) and B is false (or not present), A is false (or not present) and B is true (or present), and both A and B are true (or present).

In addition, use of "a" or "an" may be employed to describe elements and components of embodiments disclosed herein. This is done merely for convenience and "a" and "an" are intended to include "one" or "at least one," and the singular also includes the plural unless it is obvious that it is meant otherwise.

Finally, as used herein any reference to "one embodiment" or "some embodiments" means that a particular element, feature, structure, or characteristic described in connection with the embodiment is included in at least one embodiment disclosed herein. The appearances of the phrase "in some embodiments" in various places in the specification are not necessarily all referring to the same embodiment, and embodiments may include one or more of the features expressly described or inherently present herein, or any combination or sub-combination of two or more such features, along with any other features which may not necessarily be expressly described or inherently present in the instant disclosure.

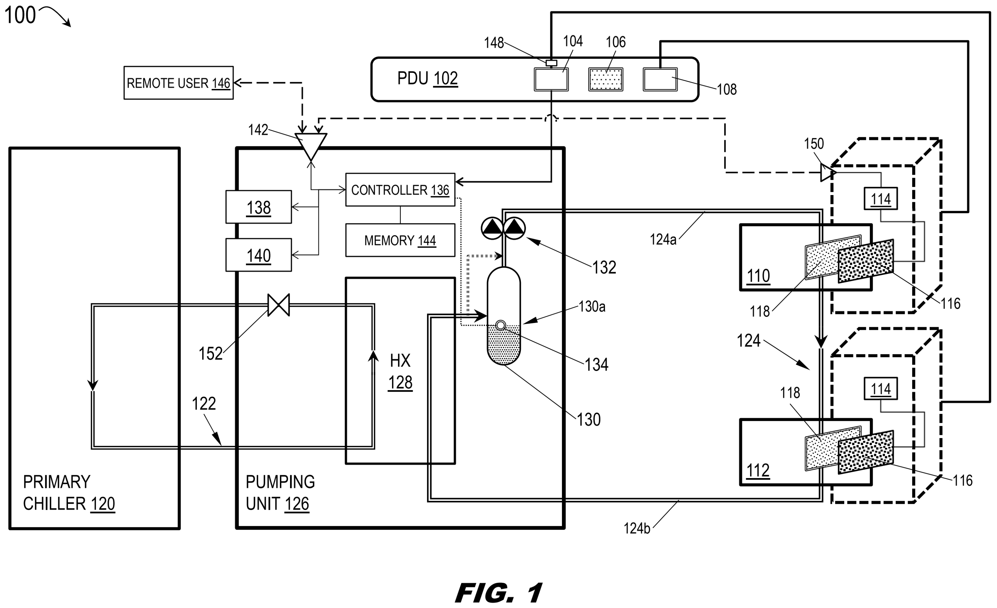

### FIG. 1 - OVERVIEW

Broadly speaking, embodiments of the inventive concepts disclosed herein are directed to methods and systems for continuous and non-intrusive monitoring of fluid refrigerant levels in a pumped two-phase cooling system configured for thermal management of servers and other IT devices within a data center environment. As noted above, the lack of sufficient charge, e.g., sufficient fluid refrigerant available in the secondary loop for heat transfer from IT devices or chip components (with respect in the latter case to direct-to-chip (D2C) cooling systems. As insufficient charge levels (e.g., liquid levels) may lead to a failure condition, continuous monitoring of available charge is essential to uninterrupted system health. Further, real-time monitoring while the system is in operation eliminates the need to shut down the system for scheduled maintenance procedures or to determine precise charge levels. Instead, if charge levels are below acceptable levels, a gentle shutdown of the system may be arranged to add refrigerant to the system.

Referring to FIG. 1, a data center environment implementing a pumped two-phase cooling system 100 is shown. The pumped two-phase cooling system 100 may include: a power distribution unit (PDU) 102 which includes outlets 104, 106, 108; information technology (IT) devices 110, 112 (e.g., servers, switches), each IT device including IT controllers 114, chip components 116, and a cold plate 118; primary cooling devices 120 (e.g., primary chiller devices, primary cooling delivery devices); primary fluid network 122; secondary fluid network 124; and a pumping unit 126. The pumping unit 126 can include a heat exchanger (HX) 128, a refrigerant reservoir 130, one or more refrigerant pumps 132, a charge level sensor 134, a pumping controller (or controller) 136, a visual display 138, a speaker 140, a communications port 142, a memory 144, a remote user 146, PDU sensors 148, an IT device network/communications port 150, and a receiver bypass (RB) valve 152

In embodiments, the pumping unit 126 may connect a primary fluid network 122 and a secondary fluid network 124, e.g., via HX 128. For example, the HX 128 may transfer heat absorbed by the fluid refrigerant circulating through the secondary fluid network 124 into the primary fluid network 122, which carries the absorbed heat away from the pumping unit 126 to be dissipated. Further, the primary fluid network 122 may connect the pumping unit 126 to the primary cooling device 120, which circulates chilled water (or another liquid refrigerant) to the HX 128. As heat generated by the chip components 116 is transferred via the cold plates 118 to the fluid refrigerant within the secondary fluid network 124, for example, the transferred heat is transferred by the HX 128 to the primary fluid network 122 and thereby to the primary cooling device 120 for removal from the pumped two-phase cooling system 100.

In embodiments, the pumped two-phase cooling system 100 may be a direct-to-chip (D2C) cooling system. For example, as noted above, the secondary fluid network 124 may circulate a dielectric fluid refrigerant into thermal contact with cold plates 118 within the IT devices 110, 112, the cold plates in thermal communication with the chip components 116. (In this way the IT devices 110, 112 may be referred to as "downstream IT devices", as said devices are disposed downstream from the pumping unit 126 with respect to the flow of liquid refrigerant through the secondary fluid network 124.) Accordingly, as the IT devices 110, 112 draw operating power, and the operating power is converted into heat by operations of the chip components 116, the heat is transferred via the cold plates 118 into the fluid refrigerant circulating through the secondary fluid network 124. The secondary fluid network 124 returns the fluid refrigerant (e.g., at a higher return temperature relative to the outlet temperature of fluid refrigerant leaving the pumping unit 126) to the HX 128 so that the heat may be transferred to the primary fluid network 122.

In embodiments, the refrigerant reservoir 130 may store the fluid refrigerant circulated by the secondary fluid network 124. For example, when the pumped two-phase cooling system 100 is in operation, the refrigerant pumps 132 may draw fluid refrigerant from the refrigerant reservoir 130 and circulate the fluid refrigerant through the IT devices 110, 112 via the secondary fluid network 124. Further, the secondary fluid network 124 may include supply piping 124a, e.g., for circulating the fluid refrigerant from the pumping unit 126 to the cold plates 118 and return piping 124b, e.g., for returning the fluid refrigerant to the refrigerant reservoir 130. In embodiments, when no load is drawn by the end devices 110, 112, the supply piping 124a and return piping 124b may be filled with liquid refrigerant, leaving the charge level 130a remaining in the refrigerant reservoir 130 relatively low. For example, as the chip components 116 activate and draw operating power, heat is generated and transferred to the liquid refrigerant, causing the liquid refrigerant to change phase into vapor and displacing liquid refrigerant back into the refrigerant reservoir 130, resulting in a higher charge level 130a.

In embodiments, the total charge includes all fluid refrigerant within the pumping unit 126 and secondary fluid network 124, regardless of state. For example, given any configuration of the pumped two-phase cooling system 100, the amount of fluid refrigerant within the refrigerant reservoir 130, e.g., the charge level 130a, may increase or decrease based on the current load or operating power drawn by any downstream IT devices 110, 112.

In embodiments, this relationship between operating power and charge level 130a may be modeled and stored to memory 144 as described below. For example, the pumped two-phase cooling system 100 in a given configuration, e.g., of primary cooling device 120, pumping unit 126, and downstream IT devices 110, 112, such that for a variety of potential load conditions the charge level 130a for each load condition may be observed and stored. In embodiments, model power data, e.g., the observed load conditions with respect to any combination of downstream IT devices 110, 112, and model charge level data, e.g., the resulting charge level 130a observed under each model set of load conditions, may be stored to memory 144 and referenced by the controller 136 in determining an expected charge level of the pumped two-phase cooling system 100 under equivalent or similar real world load conditions.

In embodiments, the controller 136 may provide real-time monitoring of fluid refrigerant levels within the refrigerant reservoir 130 by determining an expected charge level (e.g., acceptable range for charge level) based on currently observed load conditions, and by comparing this expected charge level to the actual current charge level within the refrigerant reservoir 130. If, for example, the equivalent charge level for the current set of load conditions is outside acceptable range or deviates from the expected charge level by at least a threshold amount, a low charge level alert may be generated.

Conventional approaches to charge monitoring involve a shutdown of the pumped two-phase cooling system 100, e.g., a transfer to "service mode", wherein the charge level 130a within the refrigerant reservoir 130 when the load drawn by the IT devices 110, 112 is known, e.g., zero load. Further, due to the relationship between IT load and charge level 130a, if the charge level is low, or beneath a threshold level, the risk of dry-out is significant due to the volatile nature of certain IT loads, e.g., HPC/AI pulsing loads characterized by rapid fluctuation between high and low load. For example, at low charge levels (e.g., under low-load or zero-load conditions when charge levels 130a tend to be lowest), the refrigerant pumps 132 may be unable to achieve sufficient differential pressure to circulate the fluid refrigerant. As a result, the refrigerant pumps 132 may be unable to respond to spikes in generated heat associated with pulsing loads, or may shut down entirely. As a result, system managers may add excess refrigerant to the pumped two-phase cooling system 100 as a defense or margin against IT failures driven by low charge levels. Similarly, system managers may preemptively throttle the IT devices 110, 112 and/or chip components 116 thereof as a protective measure.

In embodiments, the pumped two-phase cooling system 100 may provide continuous charge monitoring in real time by assessing on a continual basis the operating power or current load drawn by all downstream IT devices 110, 112 served by the cooling system. For example, the controller 136 may continually receive power data, e.g., current power usage and/or load conditions sensed by the PDU 102 and/or the IT devices 110, 112 themselves. Based on the modeled or historically observed relationship between IT load and charge level 130a within the refrigerant reservoir 130 (as noted above and/or as stored to memory 144), the controller 136 of the pumped two-phase cooling system 100 may determine an expected charge level, or an acceptable range within which the charge level 130a should exist, for any possible load drawn by the IT devices 110, 112 (and thus for the currently received load conditions).

In embodiments, the controller 136 may compare this expected charge level, or acceptable range for the charge level (as based on the current received power data) with the actual charge level 130a within the refrigerant reservoir 130. For example, the refrigerant reservoir 130 may include one or more charge level sensors 134 (e.g., liquid level sensors) capable of sensing the actual charge level 130a and reporting the sensed charge level to the controller 136.

In embodiments, based on the cumulative liquid-cooled operating power currently drawn (e.g., at a time t) by all chip components 116 and/or IT devices 110, 112 within the pumped two-phase cooling system 100, the controller 136 may determine an expected charge level or acceptable charge level range corresponding to the current load. Further, the controller 136 may compare this expected charge level to the contemporaneous sensed actual charge level 130a provided by the charge level sensor 134. If, for example, the actual charge level 130a at time t as determined by the controller 136 is not within the acceptable range for the current load at time t, or deviates from the expected charge level by at least a threshold amount, the controller may generate a charge level alert.

In embodiments, and as noted above, the relationship between IT load and charge level 130a may be specific to a particular configuration of the pumped two-phase cooling system 100, e.g., the number and/or specifications of the primary cooling device 120, pumping unit 126. and IT devices 110, 112. For example, the controller 136 may model charge levels 130a, and/or acceptable ranges thereof, corresponding to a spectrum of possible load conditions within the pumped two-phase cooling system 100. In embodiments, modeled acceptable ranges and/or thresholds for charge levels 130a for a variety of load conditions may be stored to memory 144 and accessed by the controller 136, e.g., when evaluating the actual sensed charge levels 130a in light of the expected charge levels based on current load conditions. For example, if the received power data matches a power data value stored to memory 144, the controller 136 may use the acceptable ranges and/or expected charge levels corresponding to the matching stored power data. However, if there is no match in memory 144 for the received power data, the controller 136 may use the acceptable ranges and/or expected charge levels corresponding to the closest available match.

In some embodiments, the controller 136 may determine an expected charge level based on a combination of training data/modeled data (e.g., based on modeling of the pumped two-phase cooling system 100) and real-time monitoring and historic data (e.g., confirmation of actual charge levels 130a based on direct observation during service periods). Further, based on historical performance data of the pumped two-phase cooling system 100, and/or the comparison of expected charge levels with actual charge levels 130a, the controller 136 may detect loss of fluid refrigerant within the secondary fluid network 124. For example, the secondary fluid network 124 may experience a gradual or rapid loss of fluid refrigerant over time, which loss may not otherwise be detected until system performance or IT operations are adversely affected. In embodiments, the controller 136 may compare a sensed current charge level 130a to expected or historical charge levels under similar load conditions. If, for example, the sensed current charge level 130a sufficiently deviates from the expected charge level, or if actual charge levels over time decline at a sufficient rate, the controller 136 may generate an alert based on the detected refrigerant loss.

In embodiments, the charge level alert may be presented to a user at or proximate to the pumping unit 126. For example, the charge level alert may be displayed via text and/or graphics on a visual display 138 of the pumping unit 126. Additionally or alternatively, the charge level alert may be presented as an aural or auditory alert via one or more speakers 140. Further still, the charge level alert may be transmitted to a remote user 146 remotely located from the pumping unit 126, e.g., via communications port 142 and according to one or more network or communications protocols, including but not limited to: Bluetooth, Simple Network Management Protocol (SNMP), Modbus, Bluetooth Low Energy (BTLE), Wi-Fi, Ethernet.

In embodiments, the controller 136 may receive power data, e.g., operating power or current load drawn by a particular IT device 112 at a time t, via sensors 148 disposed within the PDU 102. For example, the IT device 112 may be plugged into an outlet 104 of the PDU 102 and may draw operating power therefrom; the sensors 148 may provide continuous data as to, e.g., current, voltage, amperage, and other power and energy metrics to the controller 136. Further, sensors 148 may include Redfish iDVM and/or other similar sensors providing power data wirelessly to the controller 136, e.g., via a network or communications port 150 of the IT device 110.

In some embodiments, the controller 136 may receive power data directly from an IT device 110. For example, an IT controller 114 of the IT device 110 may provide continuous power data to the controller 136 via, e.g., Intelligent Platform Management Interface (IMPI).

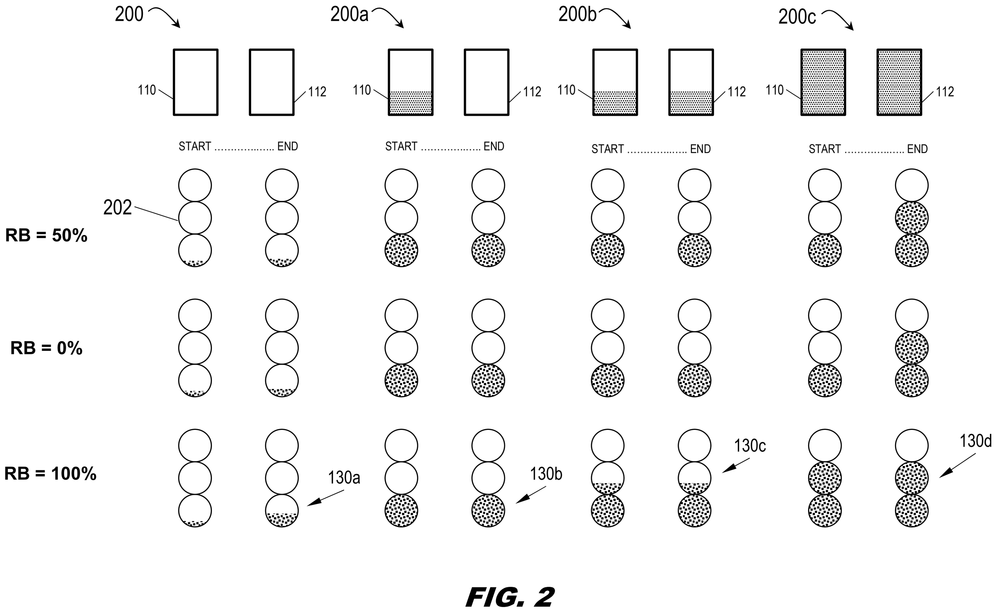

### FIG. 2 - CHARGE LEVEL MODELING

Referring to FIG. 2, the pumped two-phase cooling system 100 of FIG. 1 is shown at load conditions 200, 200a, 200b, and 200c.

In embodiments, the sight glass 202 may be physically visible within the pumping unit 126 (see FIG. 1) and may indicate (e.g., when the pumped two-phase cooling system 100 is shutdown into a "service mode" as described above) the current charge level 130a within the refrigerant reservoir 130 (see FIG. 1). For example, the sight glass 202 corresponding to each load condition 200, 200a, 200b, 200c may further be shown with respect to a receiver bypass (RB) valve 152 (see FIG. 1) in a 50% open position, in a 0% open position (i.e., fully closed), and in a 100% fully open position.

In embodiments, the controller 136 (see FIG. 1) may model and store to memory 144 (see FIG. 1) acceptable ranges and/or threshold levels for charge levels 130a corresponding to a spectrum of possible or potential load conditions within a specific configuration of the pumped two-phase cooling system 100 and IT devices 110, 112 served thereby.

In embodiments, the load condition 200 may correspond to the service mode in that no load is currently drawn by any of the IT devices 110, 112 of the pumped two-phase cooling system 100. Accordingly, the chip components 116 (see FIG. 1) of the IT devices 110, 112 are not generating heat. Therefore, no heat is being transferred to the secondary fluid network 124. As a result, no vapor is being produced within the secondary fluid network. Consequently, the secondary fluid network 124 (e.g., the supply piping 124a and return piping 124b) may be filled with liquid refrigerant, and the charge level 130a remaining in the refrigerant reservoir 130 may be minimal.

In embodiments, the load condition 200a may reflect, relative to the load condition 200, the activation of the pumped two-phase cooling system 100 and a moderate load being drawn by the IT device 110. Accordingly, a moderate amount of heat is transferred from the chip components 116 of the IT devices 110 to the secondary fluid network 124, and a moderate amount of vapor created within the secondary fluid network. The corresponding charge level 130b may therefore reflect an increased amount of fluid refrigerant within the refrigerant reservoir 130 at the increased load level.

In embodiments, the load condition 200b may reflect, relative to the load condition 200a, an additional moderate load being drawn by the IT device 112, generating a greater amount of heat transferred into the secondary fluid network 124 and consequently creating a greater amount of vapor therein. Accordingly, the corresponding charge level 130c (e.g., assuming a fully-open RB valve 152) may reflect a larger amount of fluid refrigerant remaining in the refrigerant reservoir 130.

In embodiments, the load condition 200c may reflect, relative to the load condition 200b, a maximum capacity load being drawn by both IT devices 110, 112. The correspondingly larger amount of heat transferred to the secondary fluid network 124 results in additional vapor created within the secondary fluid network, displacing even more fluid refrigerant back into the refrigerant reservoir 130 as reflected by the charge level 130d.

Based on modeling the above load conditions 200, 200a - 200c and other benchmarks corresponding to potential load conditions achievable by the specific configuration of the pumped two-phase cooling system 100 and IT devices 110, 112, the controller 136 may determine, and save to memory 144, acceptable ranges for the charge level 130a - 130d for a set of load conditions ranging from zero load (e.g., load condition 200) to maximum load (e.g., load condition 200c).

In embodiments, when the controller 136 receives power data from the PDU 102 and/or the IT devices 110, 112, the controller may first infer an expected charge level based on the current power data, then refer to contemporaneous actual charge level data 130a provided by the charge level sensors 134 to determine whether the actual charge level is within acceptable range for the current power data. If, for example, the actual charge level 130a is outside acceptable range or sufficiently deviates from the expected charge level, a charge level alert may be generated.

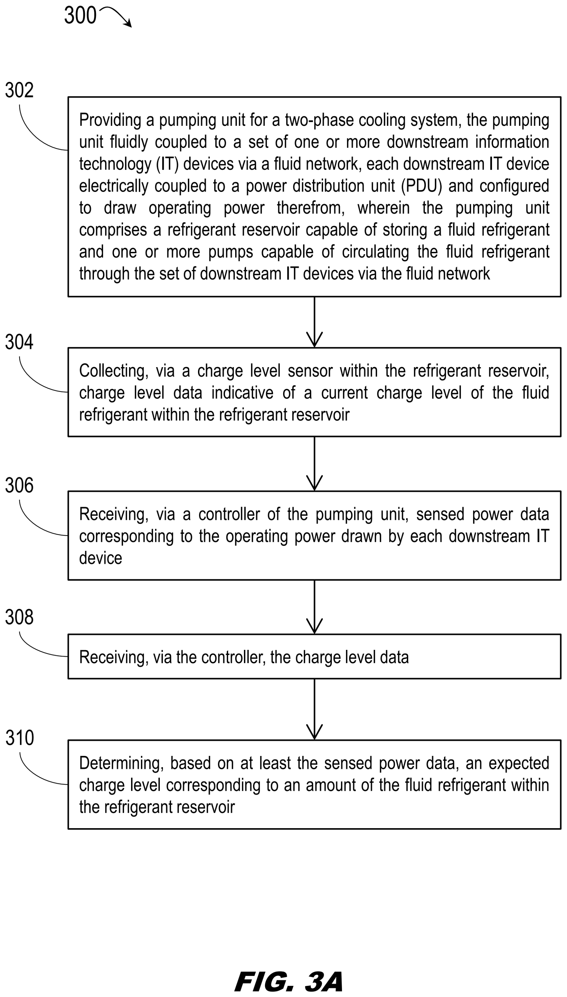

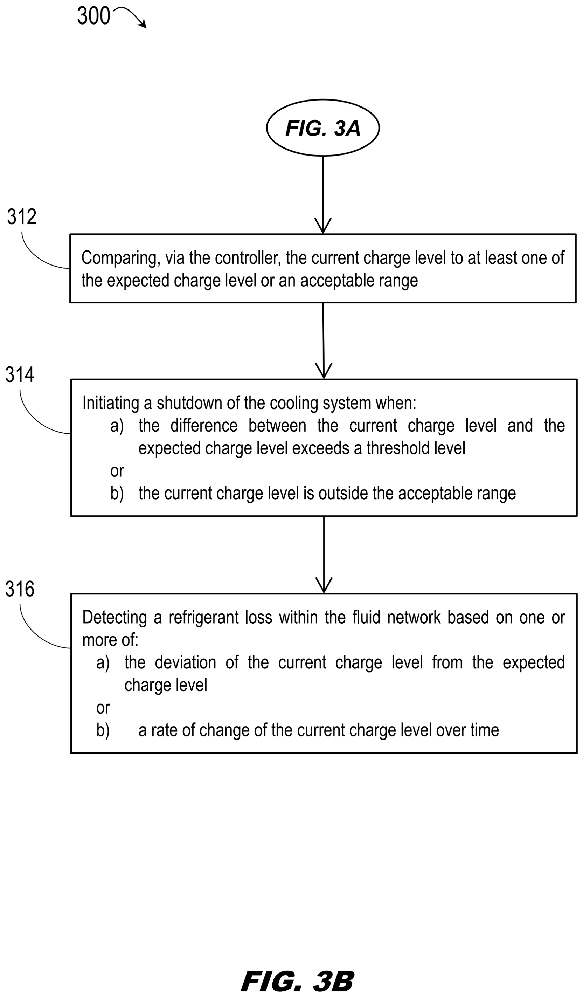

### FIGS 3A and 3B - METHOD

Referring now to FIG. 3A, the method 300 may be implemented by the 100// and may include the following steps.

At step 302, a pumping unit for a two-phase cooling system is provided, the pumping unit fluidly connected via a secondary fluid network to downstream IT devices, the downstream IT devices plugged into a power distribution unit (PDU) and drawing operating power therefrom. For example, the secondary fluid network may connect the pumping unit to downstream IT devices, circulating a fluid refrigerant through the IT devices to absorb heat therefrom. In some embodiments, the cooling system is a direct-to-chip (D2C) cooling system wherein the fluid refrigerant absorbs heat from cold plates thermally connected to chip components within the IT devices. The pumping unit includes a refrigerant reservoir for storing a fluid refrigerant and pumps for circulating the fluid refrigerant through the secondary fluid network. In some embodiments, the pumping unit controller may model charge levels corresponding to specific power levels of the IT devices, such that sensed charged levels may be compared to the modeled charge levels. Similarly, the controller may model threshold levels and/or acceptable ranges by which the deviance of sensed charge levels from expected levels (if any) may be compared or quantified. In some embodiments, the controller may store historical charge level data upon which expected charge levels for a given set of power data may be based. For example, sensed charge levels may be stored to a memory of the controller along with a timestamp and a corresponding set of sensed power data, such that later sensed charge levels may be compared to historical charge levels in order to detect deviance from expected charge levels.

At step 304, a charge level sensor within the refrigerant reservoir senses an actual charge level, e.g., a level of fluid refrigerant within the refrigerant reservoir (e.g., at a time *t).*

At step 306, a controller of the pumping unit receives sensed power data corresponding to the load current or operating power drawn by each IT device served by the pumped two-phase cooling system, e.g., at the time t. In some embodiments, sensed power data may be provided by PDU sensors connected to the outlets into which the IT devices are plugged. In some embodiments, sensed power data is provided wirelessly via IT device controllers.

At step 308, the controller receives the charge level data (e.g., at time t) from the charge level sensors.

At step 310, the controller determines, based on the received sensed power data, an expected charge level within the refrigerant reservoir (e.g., at time t). For example, the expected charge level may reflect the proportion of fluid refrigerant that should exist within the secondary fluid network, e.g., in a vaporized state due to heat transfer, and the proportion of fluid refrigerant that should be displaced by said vapor back into the refrigerant reservoir, given the sensed power data. In some embodiments, the controller infers the expected charge level by comparing the sensed power data to power data models stored to memory and specific to the configuration of the cooling system (e.g., specific to this particular pumping unit or to an equivalent pumping unit, cooling system, and set of downstream IT devices). For example, if the sensed power data matches a reference power data model, the controller refers to the charge level corresponding to that reference power data model. If there is no exact match for the sensed power data, the controller may refer to those reference power data models most closely matching the power data and their corresponding charge levels.

Referring also to FIG. 3B, at step 312, the controller compares the expected charge level (e.g., at the time t) with the actual charge level sensed at that time to determine whether the actual charge level is with an acceptable range given the current load conditions, or to what extent, if any, the actual charge level deviates from the expected charge level.

At step 314, when the sensed actual charge level is outside the acceptable range or sufficiently deviates from the expected threshold level (e.g., by at least a threshold amount), a gentle shutdown of the cooling system is initiated by the controller. In some embodiments, a charge level alert is also generated indicative of the deviant charge level. For example, the charge level may be displayed to a user textually and/or graphically via a display unit of the pumping unit. In some embodiments, the charge level alert may be an aural or auditory alert generated by a speaker of the pumping unit. In some embodiments, the charge level alert may be transmitted to a user remotely located from the pumping unit via a communications port and a physical or wireless network.

At step 316, the controller detects a loss of refrigerant within the fluid network, based on a sufficiently deviant charge level. In some embodiments, the pumping unit memory may store determined or sensed charge levels for future tracking over time. For example, when charge levels sufficiently decline over time, e.g., greater than a threshold rate of change, the controller may likewise infer a loss of refrigerant in the fluid network.

### CONCLUSION

Embodiments of the inventive concepts disclosed herein may provide a more predictable and reliable cooling system wherein the health of the system may be provided on a real time basis. Further, continuous charge monitoring may allow two-phase cooling systems to reduce or minimize the amount of refrigerant charge needed in the system without increasing the risk of low charge or dry-out conditions due to lack of heat transfer to the refrigerant. Conventional systems generally ameliorate this risk via a margin of excess refrigerant introduced into the system to prevent low-charge scenarios.

The apparatuses and methods described in this application may be partially or fully implemented by a special-purpose computer created by configuring a general-purpose computer to execute one or more particular functions embodied in computer programs. The functional blocks, flowchart components, and other elements described above serve as software specifications, which can be translated into computer programs by the routine work of a skilled technician or programmer.

The computer programs include processor-executable instructions that are stored on at least one non-transitory, tangible computer-readable medium. The computer programs may also include or rely on stored data. The computer programs may encompass a basic input/output system (BIOS) that interacts with the hardware of the special-purpose computer, device drivers that interact with particular devices of the special-purpose computer, one or more operating systems, user applications, background services, background applications, etc.

The computer programs may include: (i) descriptive text to be parsed, such as HTML (hypertext markup language), XML (extensible markup language), or JSON (JavaScript Object Notation) (ii) assembly code, (iii) object code generated from source code by a compiler, (iv) source code for execution by an interpreter, (v) source code for compilation and execution by a just-in-time compiler, etc. As examples only, source code may be written using syntax from languages including C, C++, C#, Objective-C, Swift, Haskell, Go, SQL, R, Lisp, Java^{®}, Fortran, Peri, Pascal, Curl, OCaml, Javascript^{®}, HTML5 (Hypertext Markup Language 5th revision), Ada, ASP (Active Server Pages), PHP (PHP: Hypertext Preprocessor), Scala, Eiffel, Smalltalk, Erlang, Ruby, Flash^{®}, Visual Basic^{®}, Lua, MATLAB, SIMULINK, and Python^{®}.

Process flowcharts discussed herein illustrate the operation of possible implementations of systems, methods, and computer program products according to various embodiments of the present disclosure. In this regard, each block in the flowchart may represent a module, segment, or portion of code, which comprises one or more executable instructions for implementing the specified logical function(s). It should also be noted that, in some alternative implementations, the functions noted in the blocks might occur out of the order depicted in the figures. For example, blocks shown in succession may be executed substantially concurrently. It will also be noted that each block of flowchart illustration can be implemented by special-purpose hardware-based systems that perform the specified functions or acts, or combinations of special-purpose hardware and computer instructions.

The foregoing description, for purposes of explanation, used specific nomenclature to provide a thorough understanding of the described embodiments. However, it will be apparent to one skilled in the art that the specific details are not required in order to practice the described embodiments. Thus, the foregoing descriptions of the specific embodiments described herein are presented for purposes of illustration and description. They are not intended to be exhaustive or to limit the embodiments to the precise forms disclosed. It will be apparent to one of ordinary skill in the art that many modifications and variations are possible in view of the above teachings.

## Claims

1. A pumping apparatus (126) for a two-phase cooling system (100), comprising:
a refrigerant reservoir (130) capable of storing a fluid refrigerant;
at least one charge level sensor (134) disposed within the refrigerant reservoir, the at least one charge level sensor configured to collect charge level data indicative of a current charge level of the fluid refrigerant within the refrigerant reservoir;
a fluid network (124) fluidly coupled to the refrigerant reservoir and to one or more downstream information technology (IT) devices (110,112), each downstream IT device physically connected to at least one power distribution unit "PDU" (102) and capable of drawing operating power from the PDU;
one or more pumps (132) configured to circulate the fluid refrigerant through each downstream IT device via the fluid network;
and
a controller (136) operatively coupled to the one or more pumps and to the charge level sensor, the controller including a) a memory (144) configured for storage of encoded instructions and b) at least one processor configurable by the encoded instructions to:
receive the charge level data from the at least one charge level sensor;
receive sensed power data corresponding to the operating power drawn by each downstream IT device;
determine, based on the sensed power data cumulatively associated with the one or more downstream IT devices, an expected charge level corresponding to an expected level of the fluid refrigerant within the refrigerant reservoir;
and
compare the current charge level to the expected charge level;
and
when the difference between the current charge level and the expected charge level exceeds a threshold, initiate a shutdown of the cooling system.

2. The pumping apparatus of Claim 1, wherein the at least one processor is configurable to receive the sensed power data from at least one sensor (148) associated with the at least one PDU.

3. The pumping apparatus of Claim 1 or 2, wherein the at least one processor is configurable to receive the sensed power data directly from at least one downstream IT device of the one or more downstream IT devices.

4. The pumping apparatus of any preceding Claim, wherein the two-phase cooling system is a direct-to-chip (D2C) cooling system, and:
wherein the one or more pumps are configured to circulate the fluid refrigerant from the refrigerant reservoir to at least one chip component (116) of the one or more downstream IT devices.

5. The pumping apparatus of any preceding Claim, wherein the at least one processor is configurable to:
when the current charge level deviates from the expected charge level by at least the threshold amount, generate a charge level alert.

6. The pumping apparatus of Claim 5, further comprising at least one of:
a speaker (140) capable of generating an aural alert corresponding to the charge level alert; or
a display device (138) configured to present the charge level alert to a user via at least one of text or graphics, and/or
further comprising:
at least one network port (142),
wherein the controller is configured to transmit the charge level alert to at least one remote user via the at least one network port according to at least one network protocol.

7. The pumping apparatus of any preceding Claim, wherein the controller is configured to:
determine one or more of a) a model charge level corresponding to at least one model power level of the one or more IT devices, b) a model threshold level, or c) a model acceptable range;
store, via a memory of the controller, the at least one model threshold level, model acceptable range, or model charge level and corresponding model power level;
determine the expected charge level based on the at least one model charge level corresponding to a model power level equivalent to the sensed power data;
and
determine a deviant current charge level based on at least one of the model acceptable range or the model threshold level.

8. The pumping apparatus of any preceding Claim, wherein:
the controller includes a memory configured for storing at least one historical charge level of the pumping apparatus corresponding to a previously sensed power level of the one or more IT devices;
and
wherein the controller is configured to determine the expected charge level based on the at least one historical charge level corresponding to the sensed power data,
and/or wherein:
the memory is configured to store the current charge level and a time corresponding to the charge level data;
and
wherein the at least one processor is configurable to detect a refrigerant loss within the fluid network based on one or more of:
the deviation of the current charge level from the expected charge level;
or
a rate of change of the current charge level over time.

9. A method for continuous refrigerant monitoring for a two-phase cooling system, the method comprising:
providing (302) a pumping apparatus for a two-phase cooling system, the pumping apparatus fluidly coupled to a set of one or more downstream information technology (IT) devices via a fluid network, each downstream IT device electrically coupled to a power distribution unit (PDU) and configured to draw an operating power from the PDU, wherein the pumping apparatus comprises a refrigerant reservoir capable of storing a fluid refrigerant and one or more pumps capable of circulating the fluid refrigerant through the set of downstream IT devices via the fluid network;
collecting (304), via a charge level sensor within the refrigerant reservoir, charge level data indicative of a current charge level of the fluid refrigerant within the refrigerant reservoir;
receiving (306), via a controller of the pumping apparatus, sensed power data corresponding to the operating power drawn by each downstream IT device;
receiving (308), via the controller, the charge level data;
determining (310), based on at least the sensed power data, an expected charge level corresponding to an amount of the fluid refrigerant within the refrigerant reservoir;
comparing (312), via the controller, the current charge level to at least one of the expected charge level or an acceptable range;
and
initiating (314) a shutdown of the cooling system when:
a) the difference between the current charge level and the expected charge level exceeds a threshold level;
or
b) the current charge level is outside the acceptable range.

10. The method of Claim 9, wherein receiving, via a controller of the pumping apparatus, sensed power data corresponding to the operating power drawn by each downstream IT device includes:
sensing power data corresponding to at least one downstream IT device plugged into an outlet of the PDU via a sensor associated with the outlet;
receiving, via the controller, the sensed power data from the at least one sensor, and /or
wherein receiving, via a controller of the pumping apparatus, sensed power data corresponding to the operating power drawn by each downstream IT device includes:
receiving the sensed power data corresponding to the operating power drawn from at least one downstream IT device of the set of downstream IT devices.

11. The method of Claim 9 or 10, wherein initiating a shutdown of the cooling system includes:
generating a charge level alert indicative of the deviant current charge level; and
presenting the charge level alert to at least one user.

12. The method of Claim 11, wherein presenting the charge level alert to at least one user includes:
displaying at least one visual message corresponding to the charge level alert via a display device of the pumping apparatus, the at least one visual message including one or more of text or graphics.

13. The method of Claim 11 or 12, wherein presenting the charge level alert to at least one user includes:
generating at least one aural alert corresponding to the charge level alert via a speaker of the pumping apparatus, and/or
wherein presenting the charge level alert to at least one user includes:
transmitting, via a communications port of the pumping apparatus, the charge level alert to at least one remote user according to at least one network protocol.

14. The method of any of Claims 9 to 13, wherein providing a pumping apparatus for a two-phase cooling system includes:
determining at least one of a) a model charge level corresponding to at least one model power level of the one or more IT devices, b) a model threshold level, or c) a model acceptable range;
and
storing, via a memory of the controller, the at least one model threshold level, model acceptable range, or model charge level and corresponding model power level;
wherein determining, based on at least the sensed power data, the expected charge level includes:
determining the expected charge level based on the at least one model charge level corresponding to a model power level equivalent to the sensed power data;
and
wherein comparing the current charge level to at least one of the expected charge level or an acceptable range includes comparing the current charge level to at least one of the model acceptable range or the model threshold level.

15. The method of any of Claims 9 to 14, wherein providing a pumping apparatus for a two-phase cooling system includes:
storing, via a memory of the controller, at least one historical charge level associated with a historical power level of the one or more IT devices and with at least one of the pumping apparatus or an equivalent cooling system;
and
wherein determining, based on at least the sensed power data, the expected charge level includes:
determining the expected charge level based on the at least one historical charge level corresponding to a historical power level equivalent to the sensed power data,
and/or wherein receiving, via the controller, the charge level data; includes:
storing, via a memory of the controller, the received charge level data and a time corresponding to the charge level data;
and
further comprising:
detecting (316) a refrigerant loss within the fluid network based on one or more of:
the deviation of the current charge level from the expected charge level;
or
a rate of change of the current charge level over time.
